# EUROPÄISCHE PATENTSCHRIFT

(11) **EP 1 132 709 B1**
(45) Veröffentlichungstag und Bekanntmachung des Hinweises auf die Patenterteilung: **22.11.2006**
(21) Anmeldenummer: 01104815.4
(22) Anmeldetag: 27.02.2001
(51) Int. Cl.: G01B 7/30, G01D 5/14, G01D 5/16

(54) **Drehgeber mit Rastverhalten**
Rotary transmitter with latching positions
Transmetteur rotatif avec des positions d'arrêt

(30) Priorität: 04.03.2000 DE 10010700
(43) Veröffentlichungstag der Anmeldung: 12.09.2001
(73) Patentinhaber: ddm hopt + schuler GmbH & Co. KG, D-78628 Rottweil (DE)
(72) Erfinder: Parras, Karl-Heinz, 91126 Schwabach (DE)
(74) Vertreter: Kohler Schmid Möbus

(56) Entgegenhaltungen:
- DE-A- 4 311 496
- DE-U- 9 307 156
- DE-U- 29 705 744
- DE-U- 29 713 729

## Beschreibung

Die Erfindung betrifft einen Drehgeber mit Rastverhalten. Ein inkrementeller magnetischer Drehgeber ist aus der Patentanmeldung DE 4102277 bekannt. Inkrementelle Drehgeber werden u.a. zur automatischen Messung von Winkel- und Wegpositionen oder zur manuellen Einstellung von z.B. Sollwerten eingesetzt.

Der aus der angegebenen Patentanmeldung bekannte Drehgeber hat einen Rotor mit magnetisch leitfähigen Teilen. Über diese Teile des Rotors, der wie der Stator mit Zähnen versehen ist, werden zwei magnetische Flusskreise geschlossen, die z.B. von gesonderten Permanentmagneten erzeugt werden. Diese Magnete einschließlich der sie umgebenden Sensorspulen sind ebenfalls Bestandteile des Stators.

Die magnetischen Kräfte zwischen Rotor und Stator sorgen dafür, dass der Rotor bei Drehung in bestimmten Positionen, die durch die Lage der Zähne vorgegeben sind, ein mechanisches Einrastverhalten zeigt.

Das Einrastverhalten gibt bei manueller Drehung des Rotors dem Bediener eine sichere Rückmeldung darüber, dass er die Position des Rotors um ein Inkrement verändert hat.

Beim Drehen des Rotors von einer Rastposition zur nächsten wird auch der magnetische Widerstand und damit der magnetische Fluß in den beiden magnetischen Kreisen vorübergehend verändert, wodurch Spannungen in den beiden Sensorspulen induziert werden, die durch eine elektronische Schaltung in entsprechende auswertbare Signale umgeformt werden. Die Drehrichtung des Rotors ist durch das Vorzeichen der zeitlichen Verschiebung der beiden induzierten und integrierten Spannungen erkennbar; diese Verschiebung ist wiederum eine Folge der geometrischen Anordnung der Zähne auf dem Stator. Damit z.B. keine Fehlentscheidungen über die Drehrichtung getroffen werden, sind alle Bauteile und besonders das Lager innerhalb geringer mechanischer Toleranzgrenzen zu fertigen.

Ein erster Nachteil derartiger magnetischer Drehgeber liegt darin, dass das Rastverhalten üblicherweise nicht so "hart" ist wie bei einer mechanischen Rastvorrichtung. Ein zweiter Nachteil ist darin zu sehen, dass eine Verkleinerung der Baugröße dieser Art von Drehgebern schnell an Grenzen stößt, weil damit die mechanischen Toleranzanforderungen, insbesondere bezüglich des Luftspaltes zwischen dem Stator und dem Rotor, nicht leicht zu realisieren sind und/oder die Variation des magnetischen Widerstandes zwischen labiler und gerasteter Rotorposition nicht mehr hinreichend groß werden kann. Als dritten Nachteil dieser Konstruktionen kann man den Kostenanstieg bei weiterer Miniaturisierung ansehen.

Es ist daher Aufgabe der vorliegenden Erfindung, einen magnetischen Drehgeber so zu gestalten, dass er sich durch vergleichsweise hartes Rastverhalten trotz kleiner Baugröße auszeichnet und außerdem ohne großen mechanischen Aufwand kostengünstig herstellbar ist.

Diese Aufgabe wird gemäß Anspruch 1
von einem Drehgeber mit einem Gehäuse, mit einem drehfest im Gehäuse befestigten unten offenen Statorkäfig mit axial verlaufenden Lamellen, mit einem unten offenen oberen Rotorkäfig mit breiten und schmalen Lamellen, in dem ein in axialer Richtung magnetisierter Ringmagnet bündig mit seiner oberen Stirnseite an der Innenseite der Stirnseite des oberen Rotorkäfigs anliegt, wobei ein hinreichend großer Luftspalt zwischen dem Mantel des Ringmagneten und den Lamellen des oberen Rotorkäfigs verbleibt, mit einem unten offenen unteren Rotorkäfig mit axial verlaufenden Lamellen, der mit seiner oberen Stirnseite an der unteren Stirnseite des Ringmagneten fest anliegt, mit einer im Gehäuse drehbar gelagerten Achswelle, auf der der obere Rotorkäfig, der Ringmagnet und der untere Rotorkäfig verdrehfest sitzen, mit mindestens zwei neben dem unteren Rotorkäfig angeordneten Sensoren zur Erfassung der Drehbewegung und der Winkelposition der Achswelle, wobei sich die Anordnung aus dem oberen Rotorkäfig, dem Ringmagneten und dem unteren Rotorkäfig frei drehbar im Inneren des Statorkäfigs befindet,
gelöst.

Der erfindungsgemäße Drehgeber ist aus einem Gehäuse, einem Statorkäfig mit Lamellen, einem oberen und einem unteren Rotorkäfig mit Lamellen und einem axial magnetisierten Ringmagneten aufgebaut. Der Ringmagnet sitzt im Inneren des oberen Rotorkäfigs. An der unteren Stirnseite des Ringmagneten liegt die Stirnseite des unteren Rotorkäfigs fest an. Der Statorkäfig, der obere und der untere Rotorkäfig sind unten jeweils offen. Die Anordnung aus dem oberen Rotorkäfig, dem Ringmagneten und dem unteren Rotorkäfig sitzt verdrehfest auf einer drehbar im Gehäuse gelagerten Achswelle. Neben dem Mantel des unteren Rotorkäfigs sind mindestens zwei Sensoren zur Erfassung der Drehbewegung der Achswelle angeordnet. Der Statorkäfig, in dessen Inneren die Anordnung aus den beiden Rotorkäfigen und dem Ringmagneten frei drehbar ist, ist fest mit dem Gehäuse verbunden. Die Achswelle ragt aus der Stirnseite des Gehäuses. An der Unterseite ist das Gehäuse mit einem Deckel abgeschlossen, in dem sich das zweite Lager für die Achswelle und beispielsweise Befestigungen oder Durchbrüche für die Sensoren befinden. Als Sensoren sind bevorzugt Hallsensoren mit integrierter Elektronik vorgesehen, es können aber auch andere Technologien, z.B. magnetoresistive Sensoren verwendet werden.

Der Statorkäfig, der obere und der untere Rotorkäfig sind vorzugsweise nach unten weiter werdend konisch geformt. Dies ist vorteilhaft für die Fertigung sowie die Montage und ermöglicht zudem über den Winkel dieser konischen Gestaltung die Rückstellkraft für die axiale Betätigung des Drehgebers in weiten Grenzen zu variieren. Ein spitzer Winkel bedeutet eine geringe axiale Rückstellkraft, ein stumpferer Winkel führt zu einer Vergrößerung der axialen Rückstellkraft.

Die miteinander fluchtenden Lamellen der Käfige können zur Erzielung eines optimalen magnetischen Flusses unterschiedliche Formen aufweisen und werden an die jeweiligen durch die Sensoren vorgegebenen Erfordernisse angepasst.
Da eine mechanische, verschleißbehaftete Rastvorrichtung nicht notwendig ist, führt dies zudem zu einer sehr hohen Betriebs-Lebensdauer der Anordnung.

Die Erfindung wird nun an Hand der Figuren näher beschrieben und erläutert. Es zeigen:
Figur 1
   ein erstes Ausführungsbeispiel der Erfindung in einer perspektivischen Explosionsdarstellung,
Figur 2
   einen Längsschnitt durch das erste Ausführungsbeispiel,
Figur 3
   den Signalverlauf an den Sensoren bei kontinuierlicher Betätigung,
Figur 4
   ein zweites Ausführungsbeispiel der Erfindung in einer perspektivischen Explosiónsdarstellung,
Figur 5
   einen Längsschnitt durch das zweite Ausführungsbeispiel,
Figur 6
   einen Querschnitt durch das zweite Ausführungsbeispiel und
Figur 7
   eine schematische Darstellung des magnetischen Flusses beim zweiten Ausführungsbeispiel.

### Ausführungsbeispiel 1

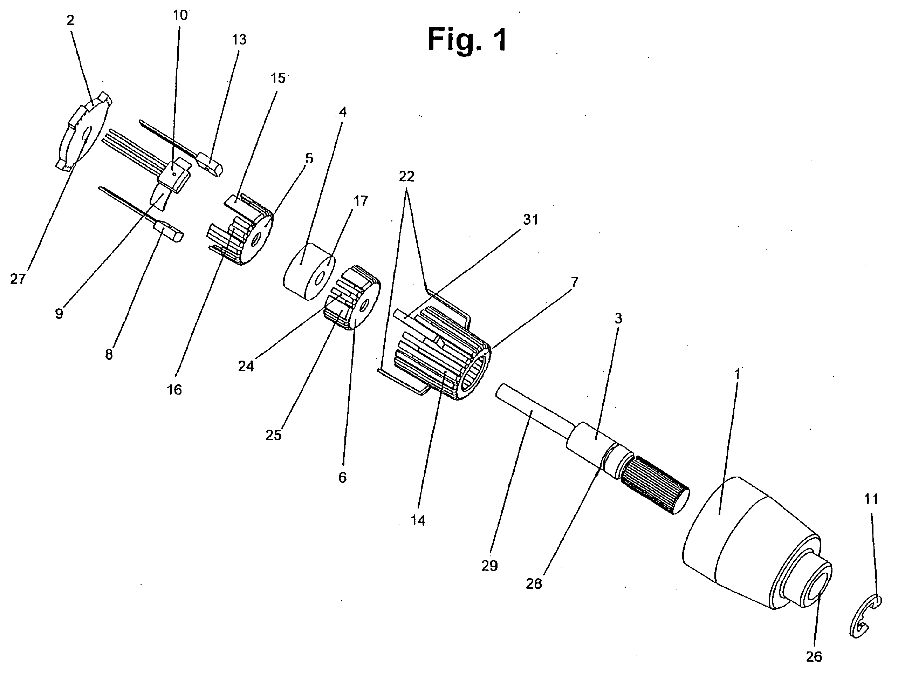

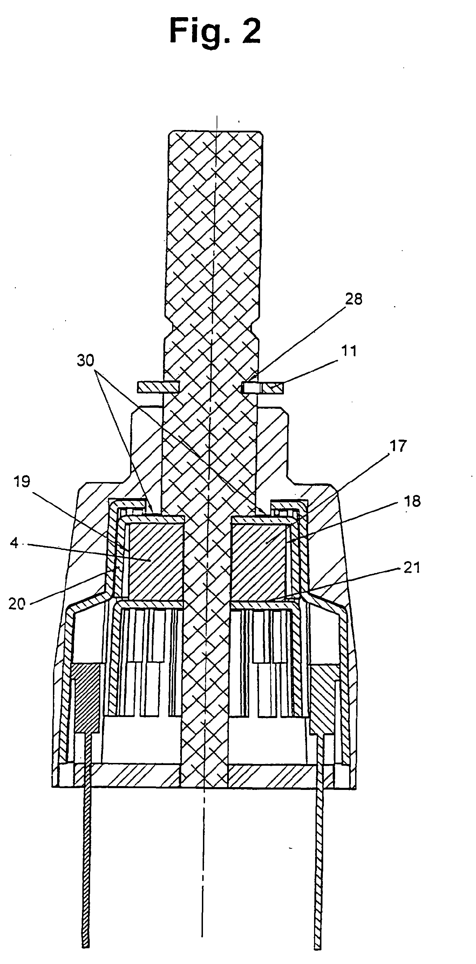

In der Figur 1 ist das erste Ausführungsbeispiel der Erfindung für 20 Rastpositionen in Explosionsdarstellung gezeigt. Figur 2 zeigt einen Längsschnitt durch das erste Ausführungsbeispiel.

Die gesamte Anordnung befindet sich in einem bevorzugt aus Plastik-Spritzguss gefertigten Gehäuse 1, das nach unten mit einem passenden Gehäusedeckel 2 abgeschlossen wird. Die aus magnetisch nicht leitendem Material wie Messing oder Aluminium gefertigte Achswelle 3 wird in einer Lagerbuchse 26 des Gehäuses 1 und einer weiteren Lagerbuchse 27 des Gehäusedeckels 2 drehbar und axial um einen kleinen Weg verschiebbar gelagert. Sie hat im vorderen Teil einen üblichen Durchmesser von 6 mm. In fertig montiertem Zustand begrenzt ein in eine entsprechende Nut 28 der Achswelle 3 eingerasteter Sprengring 11 den axialen Betätigungsweg, indem er an die Vorderkante der Lagerbuchse anschlägt.

Auf dem auf drei Millimeter verjüngten hinteren Teil 29 der Achswelle 3 befindet sich mit dieser fest verbunden zunächst der obere Rotorkäfig 6, der axial magnetisierte Ringmagnet 4 und dann der untere Rotorkäfig 5. Oberer und unterer Rotorkäfig sind aus einem magnetisch gut leitenden Material wie z.B. Weicheisen angefertigt. Der obere Rotorkäfig 6 liegt mit seiner inneren Stirnfläche dicht an der oberen Stirnfläche 17 des Ringmagneten 4 an, der untere Rotorkäfig 5 liegt mit seiner äußeren Stirnfläche dicht an der unteren Stirnfläche des Ringmagneten 4 an. Der Ringmagnet 4 befindet sich also zu seinem größten Teil innerhalb des oberen Rotorkäfigs 6. Zwischen der Mantelfläche des Ringmagneten 4 bzw. der Stirnfläche des unteren Rotorkäfigs 5 und den Lamellen 24,25 des oberen Rotorkäfigs 6 muss ein hinreichend großer Abstand 18 vorhanden sein, um "magnetischen Kurzschluss" der beiden Pole zu vermeiden. Der obere Rotorkäfig 6 mit seinen schmalen Lamellen 24 und seinen breiten Lamellen 25 bildet also damit z.B. den Nordpol, der untere Rotorkäfig 5 mit seinen schmalen Lamellen 15 und seinen breiten Lamellen 16 den Südpol der Anordnung. Die jeweiligen Lamellen der beiden Rotorkäfige sind fluchtend ausgerichtet. Oberer Rotorkäfig 6 und unterer Rotorkäfig 5 sind zu ihrer jeweiligen Öffnung hin weiter werdend jeweils konisch mit einem Öffnungswinkel zwischen ca. 2 und 4 Grad gefertigt. Dies bringt produktionstechnische Vorteile und hat zudem eine wichtige funktionelle Bedeutung für die Rückstellkraft bei axialer Betätigung des Drehgebers. Dies wird weiter unten im Detail dargestellt.

Der Statorkäfig 7 ist ebenfalls aus magnetisch leitendem Material, z.B. Weicheisen gefertigt und ist fest mit dem Gehäuse verbunden. Dazu ist es sinnvoll, entsprechende Rast- und Führungsvorrichtungen im Gehäuse vorzusehen, in denen der Statorkäfig 7 mechanisch gehalten wird. Der Statorkäfig 7 besitzt an seiner Stirnseite eine vergleichsweise große Öffnung, durch die die Achswelle 3 und ein Anschlagring 30 an der vorderen Gehäuse-Innenseite hindurchgeführt werden. Er weist denselben konischen Öffnungswinkel wie die Rotorkäfige auf. Die 20 Lamellen sind gleichmäßig über den Umfang des Stators verteilt und in ihrer Breite auf die Lamellen der Rotorkäfige abgestimmt, d.h. sie haben dieselbe Breite wie die schmalen Rotorlamellen. Die gesamte Rotoranordnung kann sich frei innerhalb des Statorkäfigs 7 drehen, wobei die Luftspalte zwischen den Statorlamellen 14 und den Lamellen des unteren und oberen Rotorkäfigs -abgestimmt auf die erreichbaren mechanischen Toleranzen- so klein wie möglich sein sollten, damit sich in den Rastpositionen ein möglichst geringer magnetischer Widerstand zwischen oberem Rotorkäfig 6 und dem Statorkäfig 7 und auch zwischen dem unteren Rotorkäfig 5 und dem Statorkäfig 7 ausbildet.

Der magnetische Fluss verläuft also von den Lamellen des oberen Rotorkäfigs über die Lamellen des Statorkäfigs zu den Lamellen des unteren Rotorkäfigs. Dem Reluktanz-Prinzip entsprechend wird der Rotor immer in die Winkelposition gezogen, die dem nächstliegenden lokalen Minimum des magnetischen Widerstandes zwischen den beiden Rotorpolen entspricht. Auf diese Weise ergeben sich bei der vorliegenden Anordnung 20 Winkel, an denen der Rotor einrastet.

Über die nach außen abgesetzten Lamellen 22 des Statorkäfigs wird ein Teil des magnetischen Flusses durch die Sensoren 8 und/oder 13 geleitet, wenn sich eine der breiten, verlängerten Lamellen 15 des unteren Rotorkäfigs 5 im Winkelbereich des Sensors 8 bzw. 13 befindet. Diese verlängerten Lamellen 15 des unteren Rotorkäfigs 5 erstrecken sich in ihrer Breite jeweils über zwei Rastwinkel. Das bedeutet, dass bei kontinuierlicher Drehbewegung für zwei aufeinanderfolgende Rastpositionen ein relativ großer, für die zwei nächsten Rastpositionen dann ein vernachlässigbar kleiner magnetischer Fluss durch die Sensoren 8 bzw. 13 geleitet wird. Die Sensoren 8 und 13 sind dabei so angeordnet, dass sich zwei um eine Rastposition phasenversetzte Signale ergeben, aus denen in bekannter Weise die Bewegung selbst und die Drehrichtung detektiert werden können.
Die kurzen, schmalen Lamellen 16 des unteren Rotorkäfigs 5 dürfen dabei auch bei axialer Auslenkung des Rotors in die untere Anschlagposition die Sensoren 8 und 13 nicht erreichen.

Nur in dieser unteren axialen Position des Rotors kann über die verlängerte und nach außen versetzte Lamelle 31, das Flussleitblech 9 und eine der verlängerten Lamellen 15 des unteren Rotorkäfigs 5 ein magnetischer Flussanteil durch den dritten Sensor 10 verlaufen. In der vorderen axialen Anschlagposition erreichen die verlängerten Lamellen 15 den Bereich des Flussleitbleches 9 nicht, der magnetische Fluss durch den dritten Sensor 10 ist daher in dieser axialen Position vernachlässigbar klein.

Unabhängig von der Winkelposition des Rotors generiert der dritte Sensor 10 also ein Signal bei jeder axialen Rotorbewegung.

Durch die weiter oben bereits beschriebene konische Gestaltung des Statorkäfigs 7 und der Rotorkäfige 5 und 6 entsteht entsprechend dem Reluktanz-Prinzip eine Kraftkomponente, die den Rotor nach vorne und damit die Stirnseite des oberen Rotorkäfigs 6 gegen den vorderen Anschlagring 30 des Gehäuses drückt. Hierdurch wird die gewünschte axiale Ruheposition sichergestellt. Durch geeignete Abstimmung dieses konischen Öffnungswinkels lässt sich die Kraft-Weg-Charakteristik für die axiale Betätigung des Drehgebers in weiten Grenzen beeinflussen.

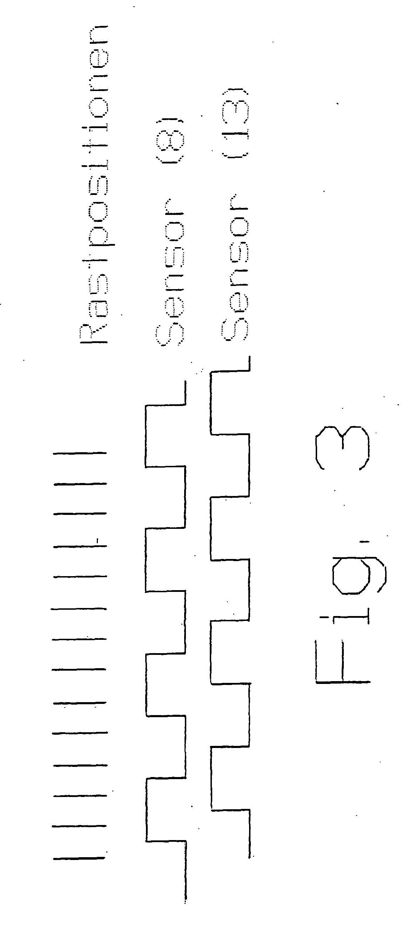

Der Signalverlauf an den Sensoren 8 und 13 ist in Fig. 3 schematisch dargestellt.

Für die Sensoren 10, 8 und 13 werden bevorzugt Hallsensoren mit integriertem Schwellwertschalter mit Hysterese verwendet, die inzwischen kostengünstig und in kleinen Bauformen verfügbar sind. Prinzipiell kann natürlich jede hinreichend empfindliche Sensortechnologie, z.B. ein magnetoresistiver Sensor mit geeigneter Auswerte-Elektronik zur Anwendung kommen.

### Ausführungsbeispiel 2

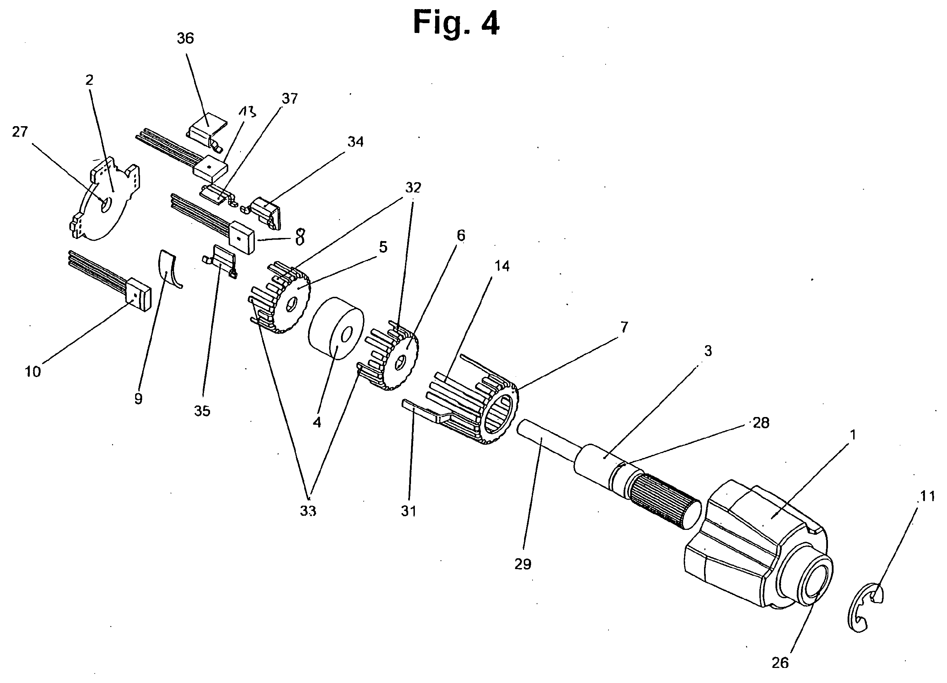

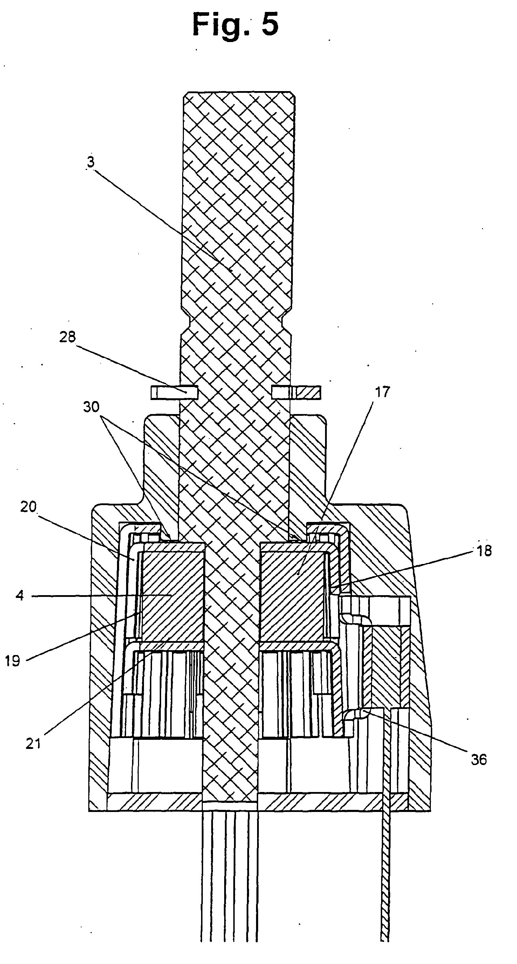

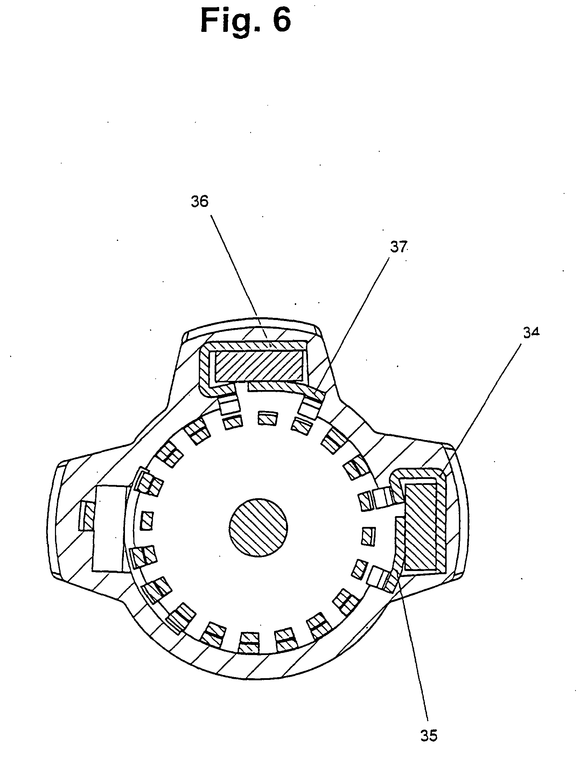

In der Figur 4 ist das zweite Ausführungsbeispiel der Erfindung für 20 Rastpositionen in Explosionsdarstellung gezeigt. Figur 5 zeigt einen Längsschnitt durch das zweite Ausführungsbeispiel, Figur 6 zeigt einen Querschnitt durch das zweite Ausführungsbeispiel.

Die gesamte Anordnung befindet sich in einem bevorzugt aus Plastik-Spritzguss gefertigten Gehäuse 1, das nach unten mit einem passenden Gehäusedeckel 2 abgeschlossen wird. Die aus magnetisch nicht leitendem Material wie Messing oder Aluminium gefertigte Achswelle 3 wird in einer Lagerbuchse 26 des Gehäuses 1 und einer weiteren Lagerbuchse 27 des Gehäusedeckels 2 drehbar und axial um einen kleinen Weg verschiebbar gelagert. Sie hat im vorderen Teil einen üblichen Durchmesser von 6 mm. In fertig montiertem Zustand begrenzt ein in eine entsprechende Nut 28 der Achswelle 3 eingerasteter Sprengring 11 den axialen Betätigungsweg, indem er an die Vorderkante der Lagerbuchse 26 anschlägt.

Auf dem auf drei Millimeter verjüngten hinteren Teil 29 der Achswelle 3 befindet sich mit dieser fest verbunden zunächst der obere Rotorkäfig 6, der axial magnetisierte Ringmagnet 4 und dann der untere Rotorkäfig 5. Oberer und unterer Rotorkäfig sind aus einem magnetisch gut leitenden Material wie z.B. Weicheisen angefertigt. Der obere Rotorkäfig 6 liegt mit seiner inneren Stirnfläche dicht an der oberen Stirnfläche 17 des Ringmagneten 4 an, der untere Rotorkäfig 5 liegt mit seiner äußeren Stirnfläche dicht an der unteren Stirnfläche des Ringmagneten 4 an. Der Ringmagnet 4 befindet sich also zu seinem größten Teil innerhalb des oberen Rotorkäfigs 6. Zwischen der Mantelfläche des Ringmagneten 4 bzw. der Stirnfläche der unteren Rotorkrone 5 und den Lamellen 32,33 des oberen Rotorkäfigs 6 muss ein hinreichend großer Abstand 18 vorhanden sein, um "magnetischen Kurzschluss" der beiden Pole zu vermeiden. Der obere Rotorkäfig 6 mit seinen kurzen Lamellen 32 und seinen langen Lamellen 33 bildet also damit z.B. den Nordpol, der untere Rotorkäfig 5 mit seinen kurzen Lamellen 32 und seinen langen Lamellen 33 den Südpol der Anordnung. Die jeweiligen Lamellen der beiden Rotorkäfige sind fluchtend ausgerichtet. Oberer Rotorkäfig 6 und unterer Rotorkäfig 5 sind zu ihrer jeweiligen Öffnung hin weiter werdend jeweils konisch mit einem Öffnungswinkel zwischen ca. 2 und 4 Grad gefertigt. Dies bringt produktionstechnische Vorteile und hat zudem eine wichtige funktionelle Bedeutung für die Rückstellkraft bei axialer Betätigung des Gebers. Dies wird weiter unten im Detail dargestellt.

Der Statorkäfig 7 ist ebenfalls aus magnetisch leitendem Material, z.B. Weicheisen gefertigt und ist fest mit dem Gehäuse verbunden. Dazu ist es sinnvoll, entsprechende Rast- und Führungsvorrichtungen im Gehäuse vorzusehen, in denen der Statorkäfig 7 mechanisch gehalten wird. Der Statorkäfig 7 besitzt an seiner Stirnseite eine vergleichsweise große Öffnung, durch die die Achswelle 3 und der Anschlagring 30 an der vorderen Gehäuse-Innenseite hindurchgeführt werden. Er weist denselben konischen Öffnungswinkel wie die Rotorkäfige auf. Die 20 Lamellen sind gleichmäßig über den Umfang des Statorkäfigs verteilt und in ihrer Breite auf die Lamellen der Rotorkäfige abgestimmt. Die gesamte Rotoranordnung kann sich frei innerhalb des Statorkäfigs 7 drehen, wobei die Luftspalte zwischen den Statorlamellen 14 und den Lamellen des unteren und oberen Rotorkäfigs - abgestimmt auf die erreichbaren mechanischen Toleranzen- so klein wie möglich sein sollten, damit sich in den Rastpositionen ein möglichst geringer magnetischer Widerstand zwischen oberem Rotorkäfig 6 und dem Statorkäfig 7 und auch zwischen dem unteren Rotorkäfig 5 und dem Statorkäfig 7 ausbildet.

Der magnetische Fluss verläuft also von den Lamellen des oberen Rotorkäfigs über die Lamellen des Statorkäfigs zu den Lamellen des unteren Rotorkäfigs. Dem Reluktanz-Prinzip entsprechend wird der Rotor immer in die Winkelposition gezogen, die dem nächstliegenden lokalen Minimum des magnetischen Widerstandes zwischen den beiden Rotorpolen entspricht. Auf diese Weise ergeben sich bei der vorliegenden Anordnung 20 Winkel, an denen der Rotor einrastet.

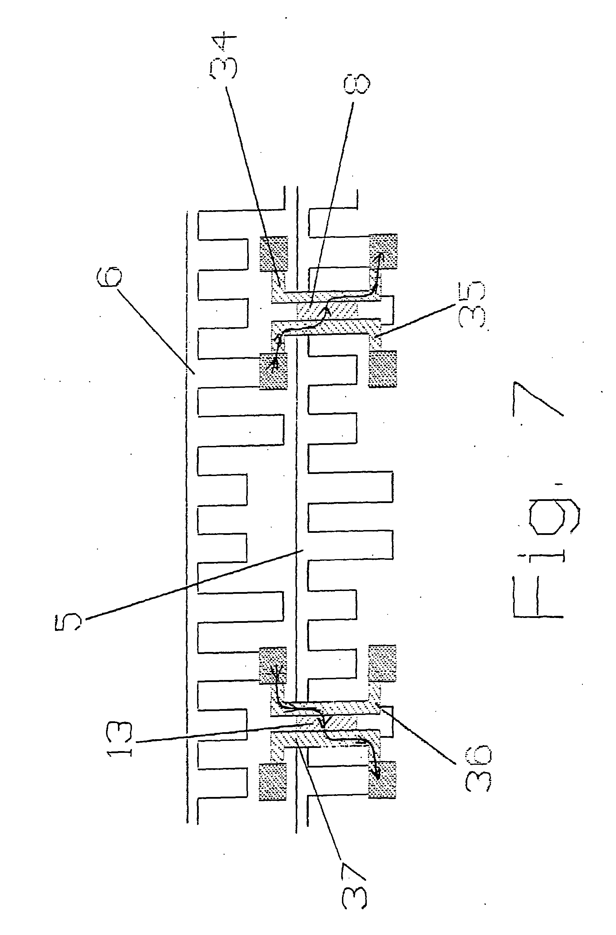

Bei diesem zweiten Ausführungsbeispiel des Drehgebers werden sogenannte bipolare Hall-Latches mit symmetrischem Schwellenwert zur Detektion der Drehbewegung und der Drehrichtung verwendet. Dies ist konstruktiv etwas aufwendiger, macht jedoch die Anordnung unempfindlich gegen z.B. starke Streuung in der Remanenzfeldstärke des Ringmagneten 4. Diese hier vorgesehenen Hall-Latches schalten erst dann, wenn sich die Flussrichtung der magnetischen Feldstärke umkehrt und dabei zudem einen vorgegebenen Schwellenwert übersteigt. Um bei Drehen der Achswelle eine Flussumkehr in den Sensoren 8,13 nach jedem zweiten Rastschritt zu erreichen, sind Flussleitbleche 34,35 bzw. 36,37 vorgesehen. Über das Zusammenspiel der Polschuhe dieser Flussleitbleche 34,35,36,37 mit den kurzen und langen Lamellen 32,33 des unteren und des oberen Rotorkäfigs 5,6 wird diese Aufgabe erfüllt. Die Polschuhe der beiden Flussleitbleche 34,35 bzw. 36,37 haben einen Abstand voneinander, der dem zweifachen Winkelabstand der Lamellen des oberen und des unteren Rotorkäfigs 6,5 entspricht. In Figur 7 wird die Umkehr des Flussverlaufs während der Drehbewegung schematisch dargestellt. Der besseren Übersicht wegen sind die Bauteile in abgewickelter Form gezeichnet.

Die Sensoren 8 und 13 und die zugehörigen Flussleitbleche 34,35,36,37 sind wieder mit entsprechendem Winkelversatz so angeordnet, dass sich zwei um eine Rastposition phasenversetzte Signale ergeben, aus denen in bekannter Weise die Bewegung selbst und die Drehrichtung detektiert werden können.

Nur in der unteren axialen Position des Rotors kann über die verlängerte und nach außen versetzte Lamelle 31, das Flussleitblech 9 und eine der langen Lamellen 33 des unteren Rotorkäfigs 5 ein magnetischer Flussanteil durch den dritten Sensor 10 verlaufen. In der vorderen axialen Anschlagposition erreichen die langen Lamellen 33 den Bereich des Flussleitbleches 9 nicht, der magnetische Fluss durch den Sensor 10 ist daher in dieser axialen Position vernachlässigbar klein.

Unabhängig von der Winkelposition des Rotors generiert der dritte Sensor 10 also ein Signal bei jeder axialen Rotorbewegung.

Durch die weiter oben bereits beschriebene konische Gestaltung des Statorkäfigs 7 und der Rotorkäfige 5 und 6 entsteht entsprechend dem Reluktanz-Prinzip eine Kraftkomponente, die den Rotor nach vorne und damit die Stirnseite des oberen Rotorkäfigs 6 gegen den vorderen Anschlagring 30 des Gehäuses drückt. Hierdurch wird die gewünschte axiale Ruheposition sichergestellt. Durch geeignete Abstimmung dieses konischen Öffnungswinkels lässt sich die Kraft-Weg-Charakteristik für die axiale Betätigung des Gebers in weiten Grenzen beeinflussen.
Für die Sensoren 8 und 13 werden bevorzugt bipolare Hall-Latches mit symmetrischer Hysterese verwendet, die inzwischen kostengünstig und in kleinen Bauformen verfügbar sind. Der dritte Sensor 10 ist ebenfalls bevorzugt ein Hallsensor mit integriertem hysteresebehaftetem Schwellwertschalter.

### Bezugszeichenliste

- 1: Gehäuse
- 2: Gehäusedeckel
- 3: Achswelle
- 4: Ringmagnet
- 5: unterer Rotorkäfig
- 6: oberer Rotorkäfig
- 7: Statorkäfig
- 8: Sensor 1
- 9: Flussleitblech
- 10: Sensor 3
- 11: Sprengring
- 13: Sensor 2
- 14: Lamellen des Statorkäfigs
- 15: breite Lamellen des unteren Rotorkäfigs
- 16: schmale Lamellen des unteren Rotorkäfigs
- 17: obere Stirnseite des Ringmagneten
- 18: Luftspalt zwischen Mantel des Ringmagneten und oberem Rotorkäfig
- 19: Mantel des Ringmagneten
- 20: Lamellen des oberen Rotorkäfigs
- 21: untere Stirnseite des Ringmagneten
- 22: abgesetzte Lamellen des Statorkäfigs
- 24: schmale Lamellen des oberen Rotorkäfigs
- 25: breite Lamellen des oberen Rotorkäfigs
- 26: vordere Lagerbuchse
- 27: hintere Lagerbuchse
- 28: Nut für Sprengring
- 29: verjüngter Teil der Achswelle
- 30: Anschlagring
- 31: abgesetzte Statorlamelle für Sensor 3
- 32: kurze Rotorlamellen
- 33: lange Rotorlamellen
- 34,35: Flußleitbleche für Sensor 1
- 36,37: Flußleitbleche für Sensor 2

## Patentansprüche

1. Drehgeber mit Rastverhalten mit einem Gehäuse (1), mit einem drehfest im Gehäuse (1) befestigten unten offenen Statorkäfig (7) mit axial verlaufenden Lamellen (14), mit einem unten offenen oberen Rotorkäfig (6) mit axial verlaufenden Lamellen (24,25;32,33), in dem ein in axialer Richtung magnetisierter Ringmagnet (4) bündig mit seiner oberen Stirnseite (17) an der Innenseite der Stirnseite des oberen Rotorkäfigs (6) anliegt, wobei ein hinreichend großer Luftspalt (18) zwischen dem Mantel (19) des Ringmagneten (4) und den Lamellen (20) des oberen Rotorkäfigs (6) verbleibt, mit einem unten offenen unteren Rotorkäfig (5) mit axial verlaufenden Lamellen (15,16;32,33) , der mit seiner oberen Stirnseite an der unteren Stirnseite (21) des Ringmagneten (4) fest anliegt, mit einer im Gehäuse (1) drehbar gelagerten Achswelle (3), auf der der obere Rotorkäfig (6), der Ringmagnet (4) und der untere Rotorkäfig (5) verdrehfest sitzen, mit mindestens zwei neben dem unteren Rotorkäfig (5) angeordneten Sensoren (8,13) zur Erfassung der Drehbewegung und der Winkelposition der Achswelle (3), wobei sich die Anordnung aus dem oberen Rotorkäfig (6), dem Ringmagneten (4) und dem unteren Rotorkäfig (5) frei drehbar im Inneren des Statorkäfigs (7) befindet.

2. Drehgeber nach Anspruch 1, **dadurch gekennzeichnet,**
**dass** die Lamellen (14,22,31) des Statorkäfigs (7) sowie des oberen und des unteren Rotorkäfigs (5,6) fluchten.

3. Drehgeber nach Anspruch 1 oder 2, **dadurch gekennzeichnet,**
**dass** der obere Rotorkäfig (6) schmale und breite Lamellen (24,25) und dass der untere Rotorkäfig (5) schmale und breite, kurze und lange Lamellen (15,16) aufweist.

4. Drehgeber nach Anspruch 1, 2 oder 3, **dadurch gekennzeichnet,**
**dass** der Statorkäfig (7) an der Position der Sensoren (8,13) verlängerte und nach außen abgesetzte auf den Sensoren (8,13) aufliegende Lamellen (22) aufweist.

5. Drehgeber nach Anspruch 1 oder 2, **dadurch gekennzeichnet,**
**dass** der Statorkäfig (7) sowie der obere und der untere Rotorkäfig (5,6) kurze und lange Lamellen (32,33) aufweisen.

6. Drehgeber nach Anspruch 5, **dadurch gekennzeichnet,**
**dass** die kurzen Lamellen (32) des oberen Rotorkäfigs (6) mit den langen Lamellen (33) des unteren Rotorkäfigs (5) und dass die langen Lamellen (33) des oberen Rotorkäfigs (6) mit den kurzen Lamellen (32) des unteren Rotorkäfigs (5) fluchten.

7. Drehgeber nach Anspruch 5 oder 6, **dadurch gekennzeichnet,**
**dass** für die Sensoren (8,13) Flussleitbleche (34,35,36,37) vorgesehen sind.

8. Drehgeber nach einem der Ansprüche 1 bis 7, **dadurch gekennzeichnet,**
**dass** der erste und der zweite Sensor (8,13) Hallsensoren oder magnetoresistive Sensoren mit hysteresebehafteten Schwellwertschaltern sind.

9. Drehgeber nach Anspruch 6 oder 7, **dadurch gekennzeichnet,**
**dass** für den ersten und zweiten Sensor (8,13) bipolare Hall-Latches vorgesehen sind.

10. Drehgeber nach einem der Ansprüche 1 bis 9, **dadurch gekennzeichnet,**
**dass** die Achswelle (3) axial verschiebbar im Gehäuse (1) gelagert ist, dass ein dritter Sensor (10) mit einem Flussleitblech (9) zur Erfassung der axialen Verschiebung der Achswelle (3) neben dem Mantel des unteren Rotorkäfigs (5) angeordnet ist und dass eine lange und nach außen abgesetzte Lamelle (31) des Statorkäfigs (7) auf dem dritten Sensor (10) aufliegt.

11. Drehgeber nach Anspruch 10, **dadurch gekennzeichnet,**
**dass** für den dritten Sensor (10) ein Hallsensor oder ein magnetoresistiver Sensor mit hysteresebehaftetem Schwellwertschalter vorgesehen ist.

12. Drehgeber nach einem der Ansprüche 1 bis 11, **dadurch gekennzeichnet,**
**dass** das Gehäuse (1) am hinteren Ende mit einem Gehäusedeckel (2) abgeschlossen ist.

13. Drehgeber nach Anspruch 12, **dadurch gekennzeichnet,**
**dass** die Sensoren (8,13,10) am Gehäusedeckel (2) befestigt sind.

14. Drehgeber nach einem der Ansprüche 1 bis 13, **dadurch gekennzeichnet,**
**dass** auf der aus dem vorderen Ende des Gehäuses (1) ragenden Achswelle (3) ein Sprengring (11) in einer Nut (28) der Achswelle (3) als Anschlag zur Begrenzung der axialen Bewegung der Achswelle (3) sitzt.

15. Drehgeber nach einem der Ansprüche 1 bis 14, **dadurch gekennzeichnet,**
**dass** auf dem aus dem vorderen Ende des Gehäuses (1) ragenden Teils der Achswelle (3) ein Drehknopf sitzt.

16. Drehgeber nach einem der Ansprüche 1 bis 15, **dadurch gekennzeichnet, dass** das Gehäuse aus einem magnetisch nicht leitenden Material gefertigt ist.

17. Drehgeber nach einem der Ansprüche 1 bis 16, **dadurch gekennzeichnet,**
**dass** die Achswelle (3) aus magnetisch nicht leitendem Material hergestellt ist.

18. Drehgeber nach einem der Ansprüche 1 bis 17, **dadurch gekennzeichnet,**
**dass** der Statorkäfig (7), der obere und der untere Rotorkäfig (5,6) aus einem magnetisch gut leitenden Material hergestellt ist.

19. Drehgeber nach einem der Ansprüche 1 bis 18, **dadurch gekennzeichnet,**
**dass** der Statorkäfig (7), der obere und der untere Rotorkäfig (6,5) konisch geformt sind.

20. Drehgeber nach einem der Ansprüche 1 bis 19, **dadurch gekennzeichnet,**
**dass** der Statorkäfig (7), der obere und der untere Rotorkäfig (6,5) gestanzt sind.

21. Drehgeber nach einem der Ansprüche 1 bis 20, **dadurch gekennzeichnet,**
**dass** die Stirnseite des oberen Rotorkäfigs (6) als Anschlag an einem Anschlagring (30) für die axiale Bewegung der Achswelle (3) vorgesehen ist.

## Claims

1. Rotary transmitter with latching positions, comprising
a housing (1),
a stator cage (7) which is open at the bottom, mounted in the housing (1) in a non-rotational manner, and has axially extending lamellas (14),
an upper rotor cage (6) which is open at the bottom and has axially extending lamellas (24, 25; 32, 33), and in which the upper front end (17) of a ring magnet (4), which is magnetized in an axial direction, abuts flush with the inner side of the front end of the upper rotor cage (6), wherein a sufficiently large air gap (18) remains between the jacket (19) of the ring magnet (4) and the lamellas (20) of the upper rotor cage (6),
a lower rotor cage (5) which is open at the bottom and has axially extending lamellas (15, 16; 32, 33), and whose upper front end solidly abuts the lower front end (21) of the ring magnet (4),
an axle shaft (3) which is rotatably disposed in the housing (1), and on which the upper rotor cage (6), the ring magnet (4) and the lower rotor cage (5) are seated for secure rotation therewith,
at least two sensors (8, 13) disposed next to the lower rotor cage (5), for detecting the rotary motion and the angular position of the axle shaft (3), wherein the arrangement of upper rotor cage (6), ring magnet (4) and lower rotor cage (5) is located in the inside of the stator cage (7) in a freely rotatable fashion.

2. Rotary transmitter according to claim 1, **characterized in that** the lamellas (14, 22, 31) of the stator cage (7), of the upper and lower rotor cages (5, 6) are aligned.

3. Rotary transmitter according to claim 1 or 2, **characterized in that** the upper rotor cage (6) has small and wide lamellas (24, 25) and the lower rotor cage (5) has small and wide, short and long lamellas (15, 16).

4. Rotary transmitter according to claim 1, 2 or 3, **characterized in that**, at the position of the sensors (8, 13), the stator cage (7) has elongated lamellas (22) which are stepped to the outside and supported on the sensors (8, 13).

5. Rotary transmitter according to claim 1 or 2, **characterized in that** the stator cage (7) and the upper and lower rotor cages (5, 6) have short and long lamellas (32, 33).

6. Rotary transmitter according to claim 5, **characterized in that** the short lamellas (32) of the upper rotor cage (6) are aligned with the long lamellas (33) of the lower rotor cage (5) and the long lamellas (33) of the upper rotor cage (6) are aligned with the short lamellas (32) of the lower rotor cage (5).

7. Rotary transmitter according to claim 5 or 6, **characterized in that** flux-conducting plates (34, 35, 36, 37) are provided for the sensors (8, 13).

8. Rotary transmitter according to any one of the claims 1 through 7, **characterized in that** the first and second sensors (8, 13) are Hall sensors or magnetoresistive sensors with hysteresis-influenced threshold switches.

9. Rotary transmitter according to claim 6 or 7, **characterized in that** bipolar Hall latches are provided for the first and second sensors (8, 13).

10. Rotary transmitter according to any one of the claims 1 through 9, **characterized in that** the axle shaft (3) is disposed in the housing (1) such that it can be axially displaced, a third sensor (10) with a flux-conducting plate (9) is disposed next to the jacket of the lower rotor cage (5) for detecting the axial displacement of the axle shaft (3), and a long and outwardly stepped lamella (31) of the stator cage (7) is supported on the third sensor (10).

11. Rotary transmitter according to claim 10, **characterized in that** a Hall sensor or a magnetoresistive sensor with a hysteresis-influenced threshold switch is provided for the third sensor (10).

12. Rotary transmitter according to any one of the claims 1 through 11, **characterized in that** the housing (1) is closed at the rear end by a housing lid (2).

13. Rotary transmitter according to claim 12, **characterized in that** the sensors (8, 13, 10) are mounted to the housing lid (2).

14. Rotary transmitter according to any one of the claims 1 through 13, **characterized in that**, on the axle shaft (3) projecting above the front end of the housing (1), a snap ring (11) is seated in a groove (28) of the axle shaft (3), acting as a stop for limiting the axial motion of the axle shaft (3).

15. Rotary transmitter according to any one of the claims 1 through 14, **characterized in that** a turning knob is disposed on the part of the axle shaft (3) projecting above the front end of the housing (1).

16. Rotary transmitter according to any one of the claims 1 through 15, **characterized in that** the housing is produced from a magnetically nonconducting material.

17. Rotary transmitter according to any one of the claims 1 through 16, **characterized in that** the axle shaft (3) is produced from a magnetically nonconducting material.

18. Rotary transmitter according to any one of the claims 1 through 17, **characterized in that** the stator cage (7), the upper and the lower rotor cages (5, 6) are produced from a material having good magnetically conducting properties.

19. Rotary transmitter according to any one of the claims 1 through 18, **characterized in that** the stator cage (7), the upper and the lower rotor cages (6, 5) have a conical shape.

20. Rotary transmitter according to any one of the claims 1 through 19, **characterized in that** the stator cage (7), the upper and the lower rotor cages (6, 5) are punched.

21. Rotary transmitter according to any one of the claims 1 through 20, **characterized in that** the front end of the upper rotor cage (6) is provided as a stop on a stop ring (30) for the axial motion of the axle shaft (3).

## Revendications

1. Transmetteur rotatif avec des positions d'arrêt équipé d'un boîtier (1), d'une cage de stator (7) ouverte inférieure fixée de manière immobile dans le boîtier (1) avec des lamelles axiales (14), d'une cage de rotor (6) ouverte supérieure avec des lamelles axiales (24, 25, 32, 33), cage dans laquelle un aimant en anneau (4) magnétisé dans la direction axiale affleure, avec sa surface de contact supérieure (17), le côté intérieur de la surface de contact de la cage de rotor (6) supérieure, sachant qu'il y a une fente d'aération (18) suffisamment grande entre le manteau (19) de l'aimant en anneau (4) et les lamelles (20) de la cage de rotor (6) supérieure, d'une cage de rotor (5) ouverte inférieure avec des lamelles axiales (15, 16, 32, 33), solidement fixée par sa surface de contact supérieure à la surface de contact inférieure (21) de l'aimant en anneau (4), d'un arbre d'axe (3) placé de manière rotative dans le boîtier (1) et sur lequel la cage de rotor (6) supérieure, l'aimant en anneau (4) et la cage de rotor (5) inférieure sont placés de manière immobile, d'au moins deux capteurs (8, 13) placés à côté de la cage de rotor (5) inférieure pour assurer la rotation et la position d'angle de l'arbre d'axe (3), sachant que l'agencement est placé de manière librement rotative à l'intérieur de la cage de stator (7) à partir de la cage de rotor (6) supérieure, de l'aimant en anneau (4) et de la cage de rotor (5) inférieure.

2. Transmetteur rotatif selon la revendication 1, **caractérisé en ce que** les lamelles (14, 22, 31) de la cage de stator (7) ainsi que de la cage de rotor supérieure et inférieure (5, 6) sont alignées.

3. Transmetteur rotatif selon la revendication 1 ou 2, **caractérisé en ce que** la cage de rotor (6) supérieure présente des lamelles étroites et larges (24, 25) et **en ce que** la cage de rotor inférieure (5) présente des lamelles étroites et larges, courtes et longues (15, 16).

4. Transmetteur rotatif selon la revendication 1, 2 ou 3, **caractérisé en ce que** la cage de stator (7) présente des lamelles (22) rallongées dans la position des capteurs (8, 13) et placées sur les capteurs (8, 13) d'une manière décalée vers l'extérieur.

5. Transmetteur rotatif selon la revendication 1 ou 2, **caractérisé en ce que** la cage de stator (7) ainsi que la cage de rotor supérieure et inférieure (5, 6) présentent des lamelles courtes et longues (32, 33).

6. Transmetteur rotatif selon la revendication 5, **caractérisé en ce que** les lamelles (32) de la cage de rotor (6) supérieure sont alignées aux lamelles longues (33) de la cage de rotor inférieure (5) et **en ce que** les lamelles longues (33) de la cage de rotor (6) supérieure sont alignées aux lamelles courtes (32) de la cage de rotor inférieure (5).

7. Transmetteur rotatif selon la revendication 5 ou 6, **caractérisé en ce que**, pour les capteurs (8, 13), il y a des tôles de conductance (34, 35, 36, 37).

8. Transmetteur rotatif selon l'une quelconque des revendications 1 à 7, **caractérisé en ce que** le premier et le deuxième capteur (8, 13) sont des capteurs de Hall ou des capteurs magnétorésistants avec des interrupteurs de valeur seuil d'hystérésis.

9. Transmetteur rotatif selon la revendication 6 ou 7, **caractérisé en ce que**, pour le premier et le deuxième capteur (8, 13), il y a des dispositifs de verrouillage bipolaires de Hall.

10. Transmetteur rotatif selon l'une quelconque des revendications 1 à 9, **caractérisé en ce que** l'arbre d'axe (3) est placé dans le boîtier (1) pour pouvoir se déplacer de manière axiale, **en ce qu'**un troisième capteur (10), équipé d'une tôle de conductance (9) afin d'assurer le déplacement axial de l'arbre d'axe (3), est placé à côté du manteau de la cage de rotor (5) inférieure et **en ce qu'**une lamelle longue et décalée vers l'extérieur (31) de la cage de stator (7) est placée sur le troisième capteur (10).

11. Transmetteur rotatif selon la revendication 10, **caractérisé en ce que**, pour le troisième capteur (10), il y a un capteur de Hall ou un capteur magnétorésistant équipé d'un interrupteur de valeur seuil d'hystérésis.

12. Transmetteur rotatif selon l'une quelconque des revendications 1 à 11, **caractérisé en ce que** le boîtier (1) est fermé au niveau de l'extrémité arrière à l'aide d'un couvercle de boîtier (2).

13. Transmetteur rotatif selon la revendication 12, **caractérisé en ce que** les capteurs (8, 13, 10) sont fixés sur le couvercle de boîtier (2).

14. Transmetteur rotatif selon l'une quelconque des revendications 1 à 13, **caractérisé en ce que**, sur l'arbre d'axe (3) sortant de l'extrémité avant du boîtier (1), un anneau à détacher (11) est placé dans une nervure (28) de l'arbre d'axe (3) comme dispositif de verrouillage pour limiter le mouvement axial de l'arbre d'axe (3).

15. Transmetteur rotatif selon l'une quelconque des revendications 1 à 14, **caractérisé en ce qu'**une tête de rotation est placée sur la partie de l'arbre d'axe (3) sortant de l'extrémité avant du boîtier (1).

16. Transmetteur rotatif selon l'une quelconque des revendications 1 à 15, **caractérisé en ce que** le boîtier est composé d'un matériau magnétiquement non conducteur.

17. Transmetteur rotatif selon l'une quelconque des revendications 1 à 16, **caractérisé en ce que** l'arbre d'axe (3) est composé d'un matériau magnétiquement non conducteur.

18. Transmetteur rotatif selon l'une quelconque des revendications 1 à 17, **caractérisé en ce que** la cage de stator (7) ou la cage de rotor supérieure et inférieure (5, 6) est composée d'un matériau magnétiquement bien conducteur.

19. Transmetteur rotatif selon l'une quelconque des revendications 1 à 18, **caractérisé en ce que** la cage de stator (7) et la cage de rotor supérieure et inférieure (5, 6) sont coniques.

20. Transmetteur rotatif selon l'une quelconque des revendications 1 à 19, **caractérisé en ce que** la cage de stator (7) et la cage de rotor supérieure et inférieure (5, 6) sont perforées.

21. Transmetteur rotatif selon l'une quelconque des revendications 1 à 20, **caractérisé en ce que** la surface de contact de la cage de rotor supérieure (6) sert de dispositif de verrouillage sur un anneau de verrouillage (30) pour le mouvement axial de l'arbre d'axe (3).
